# EUROPEAN PATENT APPLICATION

(11) **EP 4 618 087 A2**
(43) Date of publication of application: **17.09.2025**
(21) Application number: 25163687.4
(22) Date of filing: 14.03.2025
(51) Int. Cl.: G11C 17/02, G11C 7/14, G11C 17/18, G11C 11/16, G11C 13/00

(54) **REFERENCE RESISTOR HAVING VARIABLE RESISTANCE**

(30) Priority: 15.03.2024 US 202463565807 P; 10.03.2025 US 202519074925
(71) Applicant: Everspin Technologies, Inc., Chandler, Arizona 85226 (US)
(72) Inventor: XU, Haifeng, Chandler, AZ, 85226 (US); SADD, Michael A., Chandler, AZ, 85226 (US); ZHANG, Xiaohu, Chandler, AZ, 85226 (US); WILLIAMS, Jacob T., Chandler, AZ, 85226 (US); ALAM, Syed M., Chandler, AZ, 85226 (US)
(74) Representative: Eisenführ Speiser

(57) **Abstract**

A reference resistor in a magnetoresistive tunnel junction (MTJ) antifuse circuit is disclosed. The reference resistor has a variable resistance, and includes a first resistor having a first resistance, a set of second resistors each having a second resistance, and an electrical conductor layer configured to selectively electrically connect one or more second resistors in the set of second resistors to vary the variable resistance of the reference resistor.

## Description

### CROSS-REFERENCE TO RELATED APPLICATION

This application claims benefit to U.S. Provisional Patent Application No. 63/565,807 filed March 15, 2024, the entire contents of which are incorporated herein by reference.

### TECHNICAL FIELD

The present disclosure relates generally to systems and methods for mitigating errors and improving reliability of a memory device, and, more particularly, to systems and methods for a reference resistor having variable resistance.

### INTRODUCTION

Each integrated circuit chip may include billions of devices thereon, including memory devices such as magnetoresistive tunnel junctions (MTJs). In an antifuse circuit, an MTJ and a reference resistor may be electrically connected to a sensing device. The sensing device compares the electrical current through the MTJ to the electrical current through the reference resistor, and, based on the results of that comparison, outputs a logical state corresponding to the logical state of the MTJ. The characteristics (e.g., the electrical conductivity, resistance, etc.) of MTJs may vary during the follow-up process optimizations and cost reductions. It is thus desirable to have a reference resistor with a variable resistance to change the reference resistance in response to MTJs with differing characteristics.

### BRIEF DESCRIPTION OF DRAWINGS

In the course of the detailed description that follows, reference will be made to the appended drawings. The drawings show different aspects of the present disclosure and, where appropriate, reference numerals illustrating like structures, components, materials, and/or elements in different figures are labeled similarly. It is understood that various combinations of the structures, components, and/or elements, other than those specifically shown, are contemplated and are within the scope of the present disclosure.

Moreover, there are many embodiments of the present disclosure described and illustrated herein. The present disclosure is neither limited to any single aspect nor embodiment thereof, nor to any combinations and/or permutations of such aspects and/or embodiments. Moreover, each of the aspects of the present disclosure, and/or embodiments thereof, may be employed alone or in combination with one or more of the other aspects of the present disclosure and/or embodiments thereof. For the sake of brevity, certain permutations and combinations are not discussed and/or illustrated separately herein; however, all permutations and combinations are considered to fall within the scope of the present inventions.
FIG. 1 depicts an exemplary antifuse circuit.
FIG. 2 depicts an exemplary reference resistor circuit, according to one or more embodiments.
FIG. 3 depicts another exemplary reference resistor circuit, according to one or more embodiments.
FIG. 4 depicts an exemplary reference resistor programming circuit, according to one or more embodiments.
FIG. 5 depicts an exemplary reference resistor-less antifuse circuit, according to one or more embodiments.
FIG. 6 an exemplary flow diagram illustrating the operations of a reference resistor-less antifuse circuit, according to one or more embodiments.

Again, there are many embodiments described and illustrated herein. The present disclosure is neither limited to any single aspect nor embodiment thereof, nor to any combinations and/or permutations of such aspects and/or embodiments. Each of the aspects of the present disclosure, and/or embodiments thereof, may be employed alone or in combination with one or more of the other aspects of the present disclosure and/or embodiments thereof. For the sake of brevity, many of those combinations and permutations are not discussed separately herein.

### DETAILED DESCRIPTION

Detailed illustrative aspects are disclosed herein. However, specific structural and functional details disclosed herein are merely representative for purposes of describing example embodiments of the present disclosure. The present disclosure may be embodied in many alternate forms and should not be construed as limited to only the embodiments set forth herein. Further, the terminology used herein is for the purpose of describing particular embodiments only and is not intended to be limiting of exemplary embodiments described herein.

When the specification makes reference to "one embodiment" or to "an embodiment," it is intended to mean that a particular feature, structure, characteristic, or function described in connection with the embodiment being discussed is included in at least one contemplated embodiment of the present disclosure. Thus, the appearance of the phrases, "in one embodiment" or "in an embodiment," in different places in the specification does not constitute a plurality of references to a single embodiment of the present disclosure.

As used herein, the terms "comprises," "comprising," or any other variation thereof, are intended to cover a non-exclusive inclusion, such that a process, method, article, or apparatus that comprises a list of elements does not include only those elements, but may include other elements not expressly listed or inherent to such process, method, article, or apparatus. The term "exemplary" is used in the sense of "example," rather than "ideal."

As used herein, the singular forms "a," "an," and "the" are intended to include the plural forms as well, unless the context clearly indicates otherwise. It also should be noted that in some alternative implementations, the features and/or steps described may occur out of the order depicted in the figures or discussed herein. For example, two steps or figures shown in succession may instead be executed substantially concurrently or may sometimes be executed in the reverse order, depending upon the functionality/acts involved. In some aspects, one or more described features or steps may be omitted altogether, or may be performed with an intermediate step therebetween, without departing from the scope of the embodiments described herein, depending upon the functionality/acts involved.

Further, the terms "first," "second," and the like, herein do not denote any order, quantity, or importance, but rather are used to distinguish one element from another. Similarly, terms of relative orientation, such as "top," "bottom," etc. are used with reference to the orientation of the structure illustrated in the figures being described. It should also be noted that all numeric values disclosed herein may have a variation of ±10% (unless a different variation is specified) from the disclosed numeric value. Further, all relative terms such as "about," "substantially," "approximately," etc. are used to indicate a possible variation of ±10% (unless noted otherwise or another variation is specified).

Various embodiments of the present disclosure relate generally to systems and methods for mitigating errors and improving reliability of a memory device, and, more particularly, to systems and methods for a magnetoresistive device including a programmable reference resistor by including an electrical conductor layer configured to selectively electrically connect one or more resistors in a set of resistors to vary a cumulative conductive resistance.

The magnetic tunnel junction (MTJ), which may be used as and thus also referred to herein as an "antifuse bit," is a fundamental unit of a memory array and may include, among other things, two magnetic layers on opposite sides of an insulator. The two magnetic layers may include a fixed magnetic layer (also known as the reference layer) with a fixed magnetic moment and a free layer with a non-fixed magnetic moment. By changing the direction of the magnetic moment of the free layer, the logical state of the MTJ may be changed (also known as "programming" the MTJ). In antifuse applications, a programming operation refers to permanently breaking down the MTJ to reduce resistance (e.g., one time programmable antifuse memory).

MTJs are initially in an unprogrammed state because programming takes time (e.g., microseconds) and energy, which may cumulatively add up to a large amount of time and energy consumption across devices on an integrated circuit chip. Thus, the default output is a logical 0 (e.g., unprogrammed), and relatively few antifuse bits are programmed based on data storage needs.

Antifuse circuits may include one or more MTJs that can be "blown" (e.g., permanently conduct) after a certain threshold has been met. As an example, an MTJ antifuse may blow after, e.g., a threshold current has run through the MTJ. In an antifuse circuit, an MTJ and a reference resistor may be electrically connected to a sensing device. The sensing device may compare the electrical current passing through the MTJ to the current passing through the reference resistor, and, based on the results of that comparison, outputs a logical state corresponding to the logical state of the MTJ (e.g., logical 0 or logical 1). The MTJ characteristics (e.g., the electrical conductivity, resistance, etc.) may vary during the follow-up process optimization and may provide cost reductions. It may thus be desirable to have a reference resistor with a variable resistance to change the reference resistance in response to MTJs with differing characteristics.

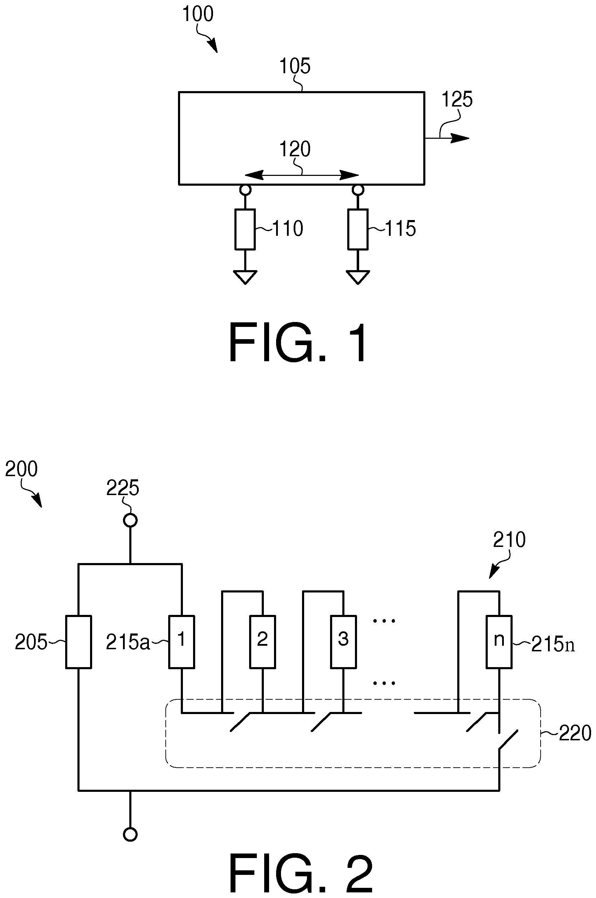

FIG. 1 illustrates an exemplary antifuse circuit 100. The antifuse circuit 100 may include a sensing device 105, an MTJ 110, a reference resistor 115, and an output 125. The sensing device 105 may be configured to compare the difference in resistance 120 (and, therefore, the difference in electrical conductivity) between the MTJ 110 and the reference resistor 115. Based on the comparison, the sensing device 105 may output a logical state (e.g., logical 0 or logical 1) corresponding to the resistance of the MTJ 110 relative to that of the reference resistor 115. For example, the resistance of the reference resistor 115 may be 1,000Ω. When the resistance of the MTJ 110 is approximately 675Ω (e.g., less than the resistance of the reference resistor 115), the output 125 may be a logical 1. When the resistance of the MTJ 110 is approximately 1,675Ω (e.g., more than the resistance of the reference resistor 115), the output 125 may be a logical 0. Based on such a comparison, the sensing device 105 may output a logical state of the antifuse circuit 100. However, if the antifuse circuit 100 includes manufacturing defects, which may change the electrical characteristics (e.g., the conductive resistance) of the MTJ 110, the results of the comparison may be undesirably and unintentionally altered.

FIG. 2 illustrates an exemplary reference resistor circuit 200, according to one or more embodiments. The reference resistor circuit 200 (also referred to herein as the reference resistor 200) may include a first resistor 205, a set of resistors 210, a conductive layer 220, and an output 225. The reference resistor circuit 200 may be configured for a variable resistance. The first resistor 205 may have a first resistance (e.g., Rnom). The first resistor 205 may be electrically connected in parallel with the set of resistors 210 (e.g., ladder of poly resistor cells, Rpgm) having a second resistance. The set of resistors 210 may include a plurality of poly resistors 215a to 215n. Each of the plurality of poly resistors 215a to 215n of the set of resistors 210 may be electrically connected in series (e.g., ladder) with one another by the conductive layer 220 (e.g., a metal layer). The conductive layer 220 may be configured to selectively electrically connect (for example, by using electrical switches) each of the plurality of poly resistors 215a to 215n in the set of resistors 210 to change the total resistance of the set of resistors 210. By selectively connecting or disconnecting the electrical connection of each of the plurality of poly resistors 215a to 215n in the set of resistors 210, the resistance of the reference resistor circuit 200 (e.g., the output 225 resistance to the sensing device) may be modulated.

As shown in FIG. 2, each resistor (e.g., poly resistor 215a to 215n) in the set of resistors 210 may be electrically connected in series with one another, and, therefore, the total resistance of the set of resistors is the sum of the resistances of R1, R2, R3... Rn. The total resistance of the set of resistors 210 therefore may increase with each additional resistor in series connection with the others. The set of resistors 210 may further be electrically connected in parallel with the first resistor 205, which may decrease the reference resistance (e.g., the output 225 resistance to the sensing device), relative to the reference resistance in a scenario where just the first resistor 205 (e.g., a single resistor) serves as the reference resistor. Effectively, the set of resistors 210 being electrically connected in parallel with the first resistor 205 may lead to a decrease in the reference resistance of the circuit 200 (e.g., the output 225 resistance to the sensing device), such that the resultant reference resistance of the circuit 200 will be less or lower than the first resistance of the first resistor 205. With each additional resistor in the set of resistors 210, the reference resistance of the reference resistor circuit 200 (e.g., the output 225 resistance to the sensing device) may increase. In this way, relative to the reference resistance in a scenario where just the first resistor 205 (e.g., a single resistor) serves as the reference resistor, a larger number of resistors included in the set of resistors 210 may result in a smaller decrease in the reference resistance, whereas a smaller number of resistors included in the set of resistors may result in a larger decrease in the reference resistance. As shown in Table 1 below, the range that the reference resistance may be reduced by the use of the reference resistor circuit 200 may be between approximately -9% and -50% of the reference resistor in the scenario where just the first resistor 205 (e.g., a single resistor) serves as the reference resistor. However, the range is not limited to the range shown in Table 1 and can be varied with more or less resistors in the circuit 200.

**Table 1**

| Fixed Unit Cell | Number of Activated Unit Cells (N) | Above Nominal | |
|---|---|---|---|
| | | Normalized Total R | Change % |
| | 1 | 0.50 | -50% |
| | 2 | 0.67 | -33% |
| | 3 | 0.75 | -25% |
| | 4 | 0.80 | -20% |
| | 5 | 0.83 | -17% |
| 1 | 6 | 0.86 | -14% |
| | 7 | 0.88 | -13% |
| | 8 | 0.89 | -11% |
| | 9 | 0.90 | -10% |
| | 10 | 0.91 | -9% |
| | ... | ... | ... |

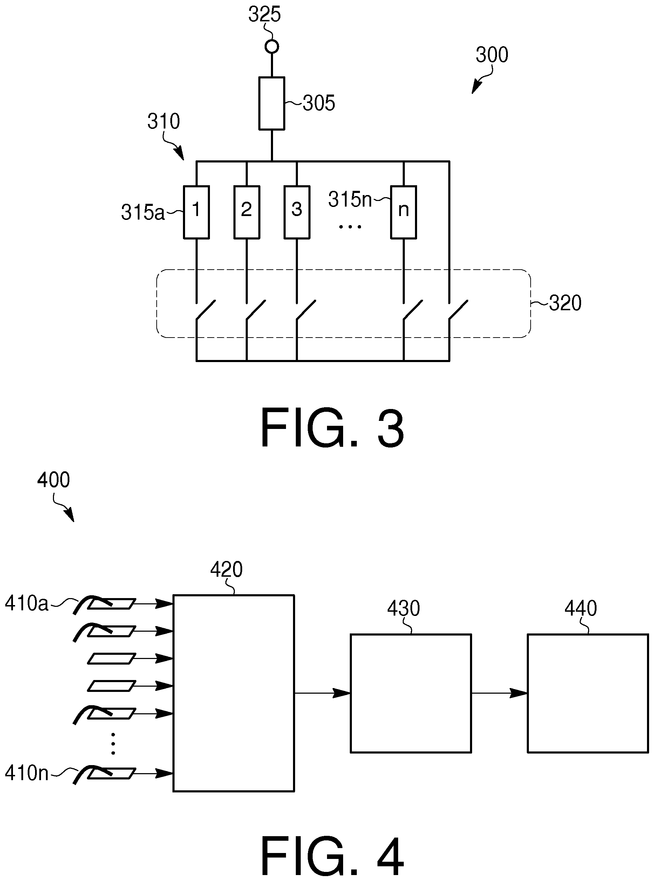

FIG. 3 illustrates an exemplary reference resistor circuit 300, according to one or more embodiments. The reference resistor circuit 300 (also referred to herein as the reference resistor 300) may include a first resistor 305, a set of resistors 310, a conductive layer 320, and an output 325. The reference resistor circuit 300 may be configured for a variable resistance. The first resistor 305 may have a first resistance (e.g., Rnom). The first resistor 305 may be electrically connected in series with the set of resistors 310 (e.g., ladder of poly resistor cells, Rpgm) having a second resistance. The set of resistors 310 may include a plurality of poly resistors 315a to 315n. Each of the plurality of poly resistors 315a to 315n of the set of resistors 310 may be electrically connected in parallel with one another by the conductive layer 320 (e.g., a metal layer). The conductive layer 320 may be configured to selectively electrically connect (for example, by using electrical switches) each of the plurality of poly resistors 315a to 315n in the set of resistors 310 to change the total resistance of the set of resistors 310. By selectively connecting or disconnecting the electrical connection of each of the plurality of poly resistors 315a to 315n in the set of resistors 310, the resistance of the reference resistor circuit 300 (e.g., the output 325 resistance to the sensing device) may be modulated.

As shown in FIG. 3, each resistor (e.g., poly resistor 315a to 315n) in the set of resistors 310 may be electrically connected in electrical series with the first resistor 305. Further, each resistor (e.g., 315a-315n) in the set of resistors 310 is connected electrically in parallel with one another, and the total resistance of the set of resistors 310 is the reciprocal sum of the reciprocal resistances of R1, R2, R3... Rn (e.g., (1/R1 +_1/R2 + 1/R3 + ... + 1/Rn)⁻¹). The total resistance of the set of resistors 310 therefore may decrease with each additional resistor in parallel connection with the others. The set of resistors 310 may further be electrically connected in series with the first resistor 305, which may increase the reference resistance (e.g., the output 325 resistance to the sensing device), relative to the reference resistance in a scenario where just the first resistor 305 (e.g., a single resistor) serves as the reference resistor. Effectively, the set of resistors 310 being electrically connected in series with the first resistor 305 may lead to an increase in the reference resistance of the circuit 300 (e.g., the output 325 resistance to the sensing device), such that the resultant reference resistance of the circuit 300 will be higher than the first resistance of the first resistor 305. With each additional resistor in the set of resistors 310, the reference resistance of the reference resistor circuit 300 (e.g., the output 325 resistance to the sensing device) may decrease. In this way, relative to the reference resistance in a scenario where just the first resistor 305 (e.g., a single resistor) serves as the reference resistor, a larger number of resistors included in the set of resistors 310 may result in a smaller increase in the reference resistance, whereas a smaller number of resistors included in the set of resistors 310 may result in a larger increase in the reference resistance. As shown in Table 2 below, the range that the reference resistance may be increased by the use of the reference resistor circuit 300 may be between approximately 10% and 100% of the reference resistor in the scenario where just the first resistor 305 (e.g., a single resistor) serves as the reference resistor. However, the range is not limited to the range shown in Table 2 and can be varied with more or less resistors in the circuit 300.

**Table 2**

| Fixed Unit Cell | Number of Activated Unit Cells (N) | Above Nominal | |
|---|---|---|---|
| | | Normalized Total R | Change % |
| | 1 | 2.00 | 100% |
| | 2 | 1.50 | 50% |
| | 3 | 1.33 | 33% |
| | 4 | 1.25 | 25% |
| | 5 | 1.20 | 20% |
| 1 | 6 | 1.17 | 17% |
| | 7 | 1.14 | 14% |
| | 8 | 1.13 | 13% |
| | 9 | 1.11 | 11% |
| | 10 | 1.10 | 10% |
| | ... | ... | ... |

Although only one set of resistors (e.g., 210 or 310) is illustrated in each of FIGS. 2 and 3 for simplicity, any number of sets of resistors may be present. Although the set of resistors is illustrated as being in parallel or in series with the first resistor (e.g., 205 or 305) in FIGS. 2 and 3, respectively, for simplicity, any number of sets of resistors may be connected in parallel, in series, or a combination thereof with the first resistor. In addition, if the programmable cells (e.g., poly resistors 215a to 215n and 315a to 315n) use the same unit cell as the nominal resistor (e.g., first resistor 205, Rnom), the benefits may include a more efficient and compact resistor layout. Additionally, the resistance value and layout of the programmable cell may not be limited to that of the nominal resistor. In one embodiment, a different value and/or layout may be used as the unit cell. This may result in more flexibility in the programmable steps and ranges. For example, a unit cell with a small or larger resistance may provide a finer programmable step compared with the data in Table 1 and/or Table 2. Further, a unit cell with a smaller or larger resistance may provide an overall narrower (e.g., smaller) programmable range compared with the data in Table 1 and/or Table 2.

FIG. 4 illustrates an exemplary reference resistor programming circuit 400, according to one or more embodiments. The reference resistor programming circuit 400 may include a plurality of chip bond pads 410a-410n, logic gates 420, a reference resistor circuit 430, and a sensing device 440. The reference resistor circuit 430 may include one or more reference resistor circuits that are substantially similar to or same as those described with respect to FIGS. 2 and 3. The sensing device 440 may be substantially similar to the sensing device 105 described with respect to FIG. 1. The plurality of chip bond pads 410a-410n may be configured to indirectly control the connectivity of electrical switches in the reference resistor circuit 430 through the logic gates 420 instead of through a conductive layer or conductive layers in a die. A connection (not shown) of one of the plurality of chip bond pads 410a to a ground, a voltage supply, or left floating (e.g., substantially free of electrical connection) may be read by other circuitry (e.g., the logic gates 420) and may be treated as a digital bit (e.g., a 1 or 0). A group of such bond pads (e.g., the plurality of chip bond pads 410a-410n) may be configured as a trim code, which another circuit (e.g., a decoder circuit) may translate to indirectly control the connectivity of individual metal-oxide semiconductor transistor switches to the resistors in the reference resistor circuit 430. The programming may be advantageously accomplished during the chip packaging.

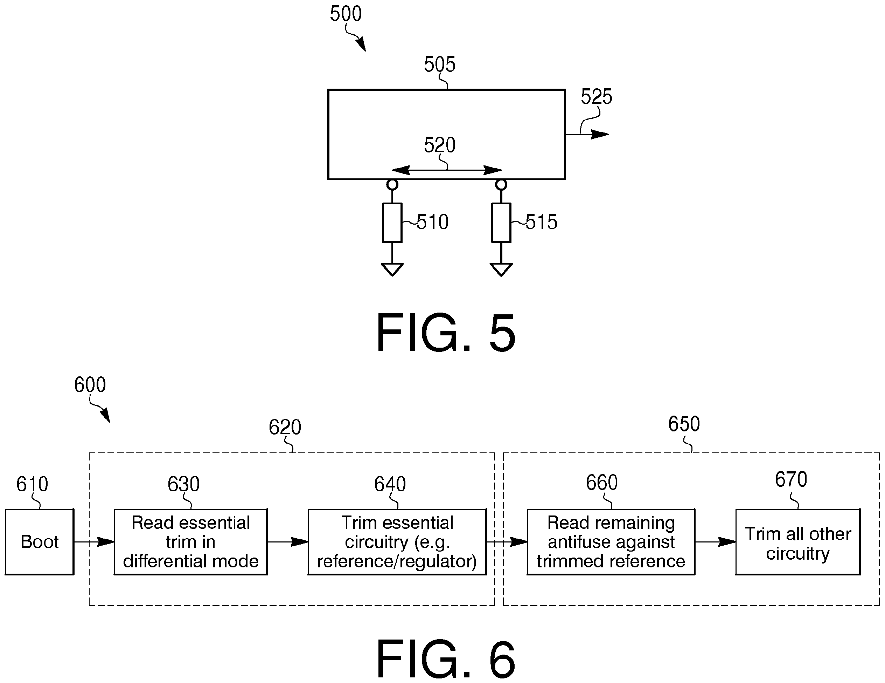

FIG. 5 illustrates a reference resistor-less antifuse circuit 500, according to one or more embodiments. The reference resistor-less antifuse circuit 500 may be substantially similar to the antifuse circuit 100 as described with respect to FIG. 1. However, the reference resistor-less antifuse circuit 500 may include certain modifications, as described herein. The reference resistor-less antifuse circuit 500 may include a sensing device 505, a first MTJ 510, a second MTJ 515, and an output 525. Notably, the reference resistor-less antifuse circuit 500 is different from the antifuse circuit 100 in FIG. 1 in that the reference resistor-less antifuse circuit 500 does not include a reference resistor. Instead, the reference resistor-less antifuse circuit 500 may be constructed using two MTJs (e.g., the first MTJ 510 and the second MTJ 515). The sensing device 505 may be configured to compare the difference in resistance 520 (and, therefore, the difference in electrical conductivity) between the first MTJ 510 and the second MTJ 515. In one embodiment, the first MTJ 510 and the second MTJ 515 may be substantially similar or substantially identical. In other embodiments, the first MTJ 510 and the second MTJ 515 may be substantially different. Before programming either the first MTJ 510 or the second MTJ 515, the antifuse state read at the output 525 of the sensing device 505 may be invalid or unknown (e.g., the logical state may be a logical 1 or a logical 0 due to unintentional manufacturing imperfections or electrical noise). An "invalid" or "unknown" state may refer to the unintentional (e.g., unprogrammed) logical state of the sensing device 505 prior to intentional programming. To reach a valid state (e.g., the output of the sensing device 505 is 1 or 0), only one of the first MTJ 510 or the second MTJ 515 is programmed. Depending on which MTJ (the first MTJ 510 or the second MTJ 515) is programmed, the sensing device 505 may determine the antifuse state as 1 or 0, respectively. To reach an invalid state, both the first MTJ 510 and the second MTJ 515 may be programmed. Table 3 below includes exemplary sensing block states.

**Table 3**

| First MTJ 510 | Second MTJ 515 | Output 525 |
|---|---|---|
| Unprogrammed | Unprogrammed | Invalid |
| Unprogrammed | Programmed | 0 |
| Programmed | Unprogrammed | 1 |
| Programmed | Programmed | Invalid |

FIG. 6 illustrates an exemplary flow diagram 600 describing a power on sequence for a reference resistor-less antifuse circuit. The flow diagram 600 may include an algorithm implemented on a computing device or system, e.g., a sense amplifier and column multiplexer, which may implement the embodiments described herein. The flow diagram 600 may include one or more steps and start with step 610. Step 610 may include a boot process for the power on sequence and may prepare to read the MTJ antifuse. At step 620, a differential mode read may include step 630 and step 640. At step 630, the system may read essential trim code in differential mode (e.g., reference resistor-less mode). After reading the essential trim code in step 630, the flow may proceed to step 640. At step 640, the essential trim code may be used to program the critical circuitry on the chip (e.g., reference resistor and/or voltage regulator).

At step 650, a non-differential mode read may be performed and include step 660 and step 670. Step 660 may include reading the remaining non-essential antifuse (e.g. non-critical block) trim values from the antifuse against the trimmed reference resistor. In doing so, a read of the antifuse level using the programmable reference resistor is performed. At step 670, the trim code may be applied to all other blocks using the trim code to trim all other circuitry on the chip.

Steps 620 and 650 may be determined to be a two-step power on sequence. The advantage of the two-step power on sequence performed in this manner may be to minimize the number of critical trim code performed in the differential mode and minimize the number of antifuses required to be blown during a separate testing state. Therefore it may reduce the testing time and energy.

For example, after booting (e.g., 610), the system may be configured to operate in a reference resistor-less mode (also referred to herein as differential mode) in which a blown (e.g., permanently conductive) MTJ antifuse (e.g., MTJ 1 or MTJ 2) may be compared to an unblown (e.g., non-conductive) MTJ antifuse. The differential mode may include an antifuse circuit without a reference resistor, as previously described herein, and the differential aspect refers to the comparative function of the algorithm in that MTJ 1 (e.g., the first MTJ 510) is compared with MTJ 2 (e.g., the second MTJ 515). Reading from differential mode may then be used to modify a reference resistor and other essential circuits.

Once the reference resistor is modified by the differential mode reading, the algorithm may include sensing a single blown antifuse (e.g., an MTJ) in comparison to the reference resistor, as discussed in other implementations described herein (e.g., a reference resistor having variable resistance). That is, the algorithm may, upon booting, read essential trim in differential mode, with the remaining data being read in non-differential mode, e.g., a mode in which a reference resistor is used. This sequence limits the number of fuses that must be blown for the differential mode to the smallest number.

The present disclosure described MTJ-based antifuse designs, however additional antifuse designs may be applicable within the scope of the disclosure. The systems and methods described herein may be applied to any other technology, e.g. RRAM, Flash, memristor, based antifuse or fuse design where a reference resistor is employed. Furthermore, the reference resistor-less design technique can be applied with any of those technologies. The reference resistor may include polysilicon, n-type semiconductor well, or diffusion resistors. In addition, the embodiments discussing the reference resistor-less design and the chip bond pads design may be combined. The effects of the combination of the embodiments may include all of the advantages discussed herein.

In one embodiment, the present disclosure is drawn to a reference resistor in a magnetoresistive tunnel junction (MTJ) antifuse circuit, the reference resistor having a variable resistance and comprising: a first resistor having a first resistance; and a set of second resistors each having a second resistance; and an electrical conductor layer configured to selectively connect and disconnect one or more second resistors in the set of second resistors to vary the variable resistance of the reference resistor.

Various aspects of the present disclosure may also include wherein the set of second resistors are at least one of: in series or in parallel with one another; wherein the first resistor is electrically connected in parallel or in series with the set of second resistors; wherein each second resistor in the set of second resistors includes polysilicon; wherein the set of second resistors are electrically connected in parallel with one another and in series with the first resistor, to increase the variable resistance of the reference resistor to be higher than the first resistance of the first resistor; wherein the set of second resistors are electrically connected in series with one another and in parallel with the first resistor, to decrease the variable resistance of the reference resistor to be lower than the first resistance of the first resistor; and wherein the variable resistance of the reference resistor is varied based on a number of second transistors, in the set of second transistors, that are in electrical connection with one another.

In another embodiment, the present disclosure is drawn to a reference resistor programming circuit comprising: a reference resistor having a variable resistance including: a first resistor having a first resistance, and a set of second resistors each having a second resistance; a set of electrical switches, wherein each electrical switch in the set of electrical switches is electrically connected to a corresponding second resistor in the set of second resistors; a decoder circuit electrically connected to each electrical switch in the set of electrical switches; and a set of bond pads electrically connected to the decoder circuit and configured to provide a trim code to the decoder circuit, wherein the decoder circuit selectively connects one or more second resistors in the set of second resistors through the corresponding one or more electrical switches based on the trim code, to vary the variable resistance of the reference resistor.

Various aspects of the present disclosure may also include wherein each second resistor in the set of second resistors is electrically connected to another second resistor in series or in parallel; wherein the first resistor is electrically connected in parallel or in series with the set of second resistors; wherein the set of second resistors includes at least one of a polysilicon resistor, an n-type semiconductor well resistor, or a diffusion resistor; wherein the set of second resistors are electrically connected in parallel with one another and in series with the first resistor, to increase the variable resistance of the reference resistor to be higher than the first resistance of the first resistor; and wherein the set of second resistors are electrically connected in series with one another and in parallel with the first resistor, to decrease the variable resistance of the reference resistor to be lower than the first resistance of the first resistor.

In yet another embodiment, the present disclosure is drawn to a magnetic tunnel junction (MTJ) antifuse circuit, comprising: a sensing block; a first MTJ cell electrically connected to the sensing block; and a second MTJ cell electrically connected to the sensing block, wherein a logical state of the sensing block includes one of a first logical state if the first MTJ is programmed and a second logical state if the second MTJ is programmed.

Various aspects of the present disclosure may also include wherein the logical state of the sensing block is valid when the first MTJ cell or the second MTJ cell is programmed; wherein the first MTJ cell and the second MTJ cell are substantially similar; wherein the first logical state is 1 and the second logical state is 0; wherein the logical state of the sensing block is invalid when both the first **MTJ** cell and the second **MTJ** cell are unprogrammed; wherein the logical state of the sensing block is determined based on a comparison of a first resistance of the first **MTJ** cell with a second resistance of the second **MTJ** cell; and wherein the logical state of the sensing block is invalid when the first **MTJ** cell and the second **MTJ** cell are programmed.

Other embodiments of the disclosure will be apparent to those skilled in the art from consideration of the specification and practice of the embodiment(s) disclosed herein. It is intended that the specification and examples be considered as exemplary only, with a true scope and spirit of the embodiment(s) being indicated by the following claims.

While exemplary embodiments have been presented above, it should be appreciated that many variations exist. Furthermore, while the description includes references to MRAM devices, the teachings may be applied to other memory devices having different architectures in which the same concepts can be applied. Thus, the particular embodiments disclosed above are illustrative only and should not be taken as limitations, as the embodiments may be modified and practiced in different but equivalent manners apparent to those skilled in the art having the benefit of the teachings herein. Accordingly, the foregoing description is not intended to limit the disclosure to the particular form set forth, but on the contrary, is intended to cover such alternatives, modifications and equivalents as may be included within the spirit and scope of the inventions as defined by the appended claims so that those skilled in the art should understand that they can make various changes, substitutions and alterations without departing from the spirit and scope of the inventions in their broadest form.

The foregoing description of the inventions has been described for purposes of clarity and understanding. It is not intended to limit the inventions to the precise form disclosed. Various modifications may be possible within the scope and equivalence of the application.

## Claims

1. A reference resistor in a magnetoresistive tunnel junction (MTJ) antifuse circuit, the reference resistor having a variable resistance and comprising:
a first resistor having a first resistance; and
a set of second resistors each having a second resistance; and
an electrical conductor layer configured to selectively connect and disconnect one or more second resistors in the set of second resistors to vary the variable resistance of the reference resistor.

2. The reference resistor of claim 1, wherein the set of second resistors are at least one of: in series or in parallel with one another, and/or wherein the first resistor is electrically connected in parallel or in series with the set of second resistors.

3. The reference resistor of claim 1 or 2, wherein each second resistor in the set of second resistors includes polysilicon.

4. The reference resistor of one of claims 1 to 3, wherein the set of second resistors are electrically connected in parallel with one another and in series with the first resistor, to increase the variable resistance of the reference resistor to be higher than the first resistance of the first resistor, or wherein the set of second resistors are electrically connected in series with one another and in parallel with the first resistor, to decrease the variable resistance of the reference resistor to be lower than the first resistance of the first resistor.

5. The reference resistor of one of the preceding claims, wherein the variable resistance of the reference resistor is varied based on a number of second transistors, in the set of second transistors, that are in electrical connection with one another.

6. A reference resistor programming circuit comprising:
a reference resistor having a variable resistance including:
a first resistor having a first resistance, and
a set of second resistors each having a second resistance;
a set of electrical switches, wherein each electrical switch in the set of electrical switches is electrically connected to a corresponding second resistor in the set of second resistors;
a decoder circuit electrically connected to each electrical switch in the set of electrical switches; and
a set of bond pads electrically connected to the decoder circuit and configured to provide a trim code to the decoder circuit, wherein the decoder circuit selectively connects one or more second resistors in the set of second resistors through the corresponding one or more electrical switches based on the trim code, to vary the variable resistance of the reference resistor.

7. The reference resistor programming circuit of claim 6, wherein each second resistor in the set of second resistors is electrically connected to another second resistor in series or in parallel.

8. The reference resistor programming circuit of claim 6 or 7, wherein the first resistor is electrically connected in parallel or in series with the set of second resistors.

9. The reference resistor programming circuit of one of claims 6 to 8, wherein the set of second resistors includes at least one of a polysilicon resistor, an n-type semiconductor well resistor, or a diffusion resistor.

10. The reference resistor programming circuit of one of claims 6 to 9, wherein the set of second resistors are electrically connected in parallel with one another and in series with the first resistor, to increase the variable resistance of the reference resistor to be higher than the first resistance of the first resistor, or wherein the set of second resistors are electrically connected in series with one another and in parallel with the first resistor, to decrease the variable resistance of the reference resistor to be lower than the first resistance of the first resistor.

11. A magnetic tunnel junction (MTJ) antifuse circuit, comprising:
a sensing block;
a first MTJ cell electrically connected to the sensing block; and
a second MTJ cell electrically connected to the sensing block,
wherein a logical state of the sensing block includes one of a first logical state if the first MTJ is programmed and a second logical state if the second MTJ is programmed.

12. The MTJ antifuse circuit of claim 11, wherein the logical state of the sensing block is valid when the first MTJ cell or the second MTJ cell is programmed.

13. The MTJ antifuse circuit of claim 11 or 12, wherein the first MTJ cell and the second MTJ cell are substantially similar.

14. The MTJ antifuse circuit of one of claims 11 to 13, wherein the logical state of the sensing block is invalid when both the first MTJ cell and the second MTJ cell are unprogrammed.

15. The MTJ antifuse circuit of one of claims 11 to 14, wherein the logical state of the sensing block is determined based on a comparison of a first resistance of the first MTJ cell with a second resistance of the second MTJ cell.
